| (19) | Europäisches Patentamt<br>European Patent Office<br>Office européen des brevets | (11) | **EP 0 451 311 B1** |

## (12) EUROPÄISCHE PATENTSCHRIFT

(45) Veröffentlichungstag und Bekanntmachung des Hinweises auf die Patenterteilung:
**10.03.1999 Patentblatt 1999/10**

(51) Int Cl.$^6$: **G03F 7/38**

(21) Anmeldenummer: **90107013.6**

(22) Anmeldetag: **12.04.1990**

(54) **Verfahren zur Erzeugung einer Resiststruktur**

Process for obtaining a resist pattern

Procédé pour la fabrication d'un modèle de réserve

(84) Benannte Vertragsstaaten:
**BE DE FR GB IT NL**

(43) Veröffentlichungstag der Anmeldung:
**16.10.1991 Patentblatt 1991/42**

(73) Patentinhaber: **SIEMENS AKTIENGESELLSCHAFT**
**80333 München (DE)**

(72) Erfinder:
- **Sezi, Recai, Dr., Dipl.-Chem.**
  **D-8551 Röttenbach (DE)**
- **Horst, Borndörfer, Dipl.-Chem.**
  **D-8520 Erlangen (DE)**
- **Rissel, Eva-Maria**
  **D-8550 Forchheim (DE)**
- **Leuschner, Rainer, Dr., Dipl.-Chem**
  **D-8521 Grossenseebach (DE)**
- **Sebald, Michael, Dr., Dipl.-Chem**
  **D-8521 Hessdorf (DE)**
- **Ahne, Hellmut, Dr., Dipl.-Chem**
  **D-8551 Röttenbach (DE)**
- **Birkle, Siegfried, Dr., Dipl.-Chem**
  **D-8552 Höchstad (DE)**

(56) Entgegenhaltungen:
**EP-A- 0 100 938**    **EP-A- 0 229 917**
**EP-A- 0 354 536**

## Beschreibung

Die Erfindung betrifft ein Verfahren zur Erzeugung einer hochaufgelösten Reststruktur mit steilen Flanken.

Die Erzeugung von Reststrukturen spielt insbesondere in der Mikroelektronik eine wichtige Rolle, beispielsweise bei der Herstellung von Halbleiterbauelementen; dazu dienen Photoresists, die auf photolithographischem Weg strukturiert werden. Die fortschreitende Entwicklung in der Mikroelektronik bringt nun aber eine Zunahme der Integrationsdichte mit sich, und bei immer kleiner werdenden Strukturen werden auch an die Strukturerzeugung immer höhere Ansprüche gestellt. Dabei ist insbesondere eine zunehmend höhere Auflösung bzw. ein zunehmend höherer Kontrast der verwendeten Photoresists erforderlich.

Bei der Strukturierung von Photoresists auf photolithographischem Weg bestimmen - neben technologischen und resistspezifischen Parametern - auch Eigenschaften der zur Belichtung verwendeten Stepper bzw. der Stepperlinse die erreichbare minimale Strukturgröße CD (= Critical Dimension) sowie die Tiefenschärfe DOF (= Depth of Focus). Die stepperspezifischen Einflußgrößen Belichtungswellenlänge $\lambda$ und numerische Apertur NA (der Linse) stehen mit CD und DOF in folgendem Zusammenhang:

$$CD = f_1 \; (\lambda/NA)$$

und

$$DOF = \pm \, f_2 \; (\lambda/NA^2);$$

$f_1$ und $f_2$ stellen dabei verfahrens- bzw. anlagespezifische Faktoren dar.

Den Anforderungen der Photolithographie genügten beispielsweise lange Zeit naßentwickelbare Einlagenresists, insbesondere solche, welche aus Novolakharzen (als Basispolymer) und Chinondiaziden (als photoaktive Komponente) bestehen. Die zukünftigen Anforderungen, wie die Strukturierung mit Excimerlasersteppern im DUV-Bereich (= Deep UV) zur Erzeugung von Reliefstrukturen unterhalb 0,5 μm mit senkrechten Flanken bei hoher Resistdicke, können derartige Resistsysteme aber kaum mehr oder gar nicht erfüllen; dies gilt insbesondere bei stufigen Substrattopographien und bei hochreflektierenden Unterlagen. Da zur Erzeugung sehr kleiner Strukturen kürzere Belichtungswellenlängen und hohe numerische Aperturen benötigt werden, gerade dies aber den Bereich der Tiefenschärfe verkleinert, ist es nämlich bei naßentwickelbaren Einlagenresists sehr schwierig, bei relativ dicken Resistschichten und unvermeidbaren Schichtdickenschwankungen auf Stufentopographien eine hohe Auflösung zu erzielen. Darüber hinaus sind Systeme der genannten Art für den Einsatz als DUV-Resist ungeeignet, insbesondere wegen der hohen Eigenabsorption von Novolaken, beispielsweise bei 248 nm.

Um die mit der Verwendung von naßentwickelbaren Einlagenresists verbundenen Probleme zu beseitigen, wurden sogenannte Zweilagensysteme entwickelt, die allerdings kompliziert sind. Bei den Zweilagensystemen wird nur eine obere dünne Schicht belichtet und strukturiert, d.h. entwickelt oder durch Behandlung mit einem Agens chemisch verändert, und die hierbei erzeugte Struktur wird anschließend in die untere(n) Schicht(en) übertragen; die obere Schicht dient dabei als Kontaktmaske. Zur Strukturierung der unteren Schicht kann beispielsweise UV-Licht (Flutbelichtung) in Verbindung mit einer Naßentwicklung oder einer Trockenentwicklung, wie reaktives Ionenätzen im Sauerstoffplasma ($O_2$/RIE), dienen.

Die Vorteile der Zweilagensysteme, bei gleichzeitig geringerer Komplexität, besitzen trockenentwickelbare Einlagensysteme. Bei diesen Systemen wird in einer auf ein Substrat aufgebrachten Resistschicht durch Belichten der Oberfläche ein latentes Bild erzeugt. Dann wird der Resist mit einem metallhaltigen organischen Reagenz behandelt, beispielsweise mit einer Organosiliciumverbindung, wobei - je nach Prozeßführung - entweder nur die belichteten Bereiche (Negativresist) oder nur die unbelichteten Bereiche (Positivresist) mit dem Reagenz reagieren. Durch Ätzen im Sauerstoffplasma erfolgt anschließend eine Trockenentwicklung der nicht-silylierten Bereiche.

Zur Erzeugung von Reststrukturen im Bereich unterhalb 0,5 μm mittels trockenentwickelbarer Einlagensysteme sind folgende Resists bzw. Prozeßtechniken bekannt:

- Ein aus einem Novolak und einer photoaktiven Komponente bestehender Resist wird - nach der Belichtung - bei 65°C mit einer Lösung von Hexamethylcyclotrisilazan in o-Xylol behandelt und anschließend trocken entwickelt; dabei ist eine Strukturierung sowohl als Negativ- als auch als Positivresist möglich (EP-OS 0 204 253).

- Bei einem Resist auf Acrylatbasis ergibt sich nach der Belichtung mittels Elektronenstrahlen, Behandlung mit Diboran ($B_2H_6$) bei 40°C und Trockenentwicklung eine Auflösung von 0,5 μm (Resistrestdicke: 0,18 μm); ähnliche Resultate werden mit einem kommerziell erhältlichen Resist und Siliciumtetrachlorid ($SiCl_4$) als Behandlungsreagenz erhalten. Dabei ist - je nach Prozeßführung - die Erzeugung von positiven oder negativen Strukturen möglich (EP-OS 0 136 130).

- Durch Behandlung von belichteten Resists mit Isocyanaten und siliciumhaltigen Reagenzien und nachfolgende Trockenentwicklung werden - bei geeigneter Prozeßführung - positive Bilder erhalten (EP-OS 0 229 917 und EP-OS 0 251 241).

- Die Silylierung von Resists mit siliciumhaltigen Reagenzien, wie Hexamethyldisilazan, aus der Gasphase ermöglicht die Erzeugung positiver Resistbilder (EP-OS 0 248 779 sowie "Proc. of SPIE", Vol. 1086 (1989), Seiten 220 bis 228, und "J. Vac. Sci. Technol. B", Vol. 7 (1989), Seiten 1782 bis 1786).

Bei den vorstehend genannten Systemen ergeben sich jedoch folgende Nachteile:

- Verwendung von korrosiven oder giftigen, feuchteempfindlichen Gasen bzw. Flüssigkeiten;
- Bedarf an speziellen evakuierbaren Apparaturen;
- Behandlung bei erhöhter Temperatur;
- lange Prozeßzeiten;
- geringe $O_2$/RIE-Resistenz.

In DE-A-3 913 434 wird ein negativ arbeitendes, trockenentwickelbares Resistsystem vorgeschlagen, das - im Gegensatz zu vergleichbaren anderen Systemen - eine einfache Handhabung erlaubt, eine hohe Selektivität im Sauerstoffplasma aufweist, zu hochaufgelösten Strukturen mit steilen Flanken führt und in vorhandenen üblichen Apparaturen zur Anwendung gelangen kann. Eine Besonderheit dieses Systems besteht darin, daß die Behandlung des Resists mit einem metallhaltigen organischen Reagenz in einer wäßrigen oder Wasser enthaltenden, nicht-toxischen Phase erfolgt und unter Normalbedingungen, d.h. bei Raumtemperatur und Normaldruck, durchgeführt wird.

Während negativ arbeitende, trockenentwikkelbare Einlagensysteme im allgemeinen einfacher zu verarbeiten sind als entsprechende positiv arbeitende Systeme, eignen sich die Positivsysteme für die Anwendung bei kritischen Kontaktlochebenen besser als die Negativsysteme. Dies ist aber ein sehr wesentlicher Vorteil.

Aufgabe der Erfindung ist es, ein Verfahren zur Erzeugung einer Resiststruktur anzugeben, das auch bei kritischen Kontaktlochebenen zu hochaufgelösten Strukturen mit steilen Flanken führt, wobei übliche Apparaturen zum Einsatz gelangen können.

Dies wird erfindungsgemäß dadurch erreicht,

- daß auf ein Substrat eine Photoresistschicht aus einem chemisch reaktive Gruppen enthaltenden Polymer und einer photoaktiven Komponente auf der Basis von Diazoketon oder Chinondiazid aufgebracht wird,
- daß die Photoresistschicht bildmäßig belichtet wird,
- daß die belichtete Photoresistschicht mit einer polyfunktionellen organischen Verbindung behandelt wird, deren funktionelle Gruppen zu einer chemischen Reaktion mit den reaktiven Gruppen des Polymers befähigt sind,
- daß nachfolgend eine Flutbelichtung erfolgt,
- daß die derart belichtete Photoresistschicht mit einer metallhaltigen organischen Verbindung behandelt wird, die wenigstens eine funktionelle Gruppe besitzt, die zu einer chemischen Reaktion mit den reaktiven Gruppen des Polymers befähigt ist,
- und daß die derart behandelte Photoresistschicht in einem sauerstoffhaltigen Plasma geätzt wird.

Durch die Erfindung wird ein Strukturierungsverfahren mit Trockenentwicklung bereitgestellt, das positive Bilder liefert und somit die mit positiv arbeitenden Resistsystemen verbundenen Vorteile bietet. Darüber hinaus weist dieses Verfahren aber auch die Vorteile auf, die vergleichbaren Negativsystemen eigen sind.

Das erfindungsgemäße Verfahren nimmt im allgemeinen folgenden Verlauf. Ein Resist, der aus einem Basispolymer und einer photoaktiven Komponente besteht, wird in Form einer Lösung auf eine Unterlage, beispielsweise einen Siliciumwafer, aufgebracht und über eine Maske belichtet. Das Basispolymer weist chemisch reaktive Gruppen auf, ist aber dennoch lagerbeständig. Als photoaktive Komponente dienen Diazoketone oder Chinondiazide. Je nach der Art der photoaktiven Komponente, die im Bereich der Belichtungswellenlänge absorbieren und reagieren muß, kann der Resist im nahen oder tiefen UV-Bereich (NUV bzw. DUV) belichtet werden, beispielsweise bei 193, 248, 313, 365 oder 436 nm.

Nach der Belichtung wird der Resist kurzzeitig mit einem sogenannten Vernetzungsreagenz behandelt, vorteilhaft in Form einer wäßrigen Lösung. Als Vernetzungsreagenzien dienen dabei metallfreie organische Verbindungen, die über mindestens zwei funktionelle Gruppen verfügen, welche mit den reaktiven Gruppen des Basispolymers eine chemische Reaktion eingehen können. Durch diese Reaktion wird in den belichteten Bereichen das Basispolymer blockiert. Durch die Behandlung mit der Lösung des Vernetzungsreagenz wird vermutlich die bei der Belichtung aus der photoaktiven Komponente entstandene Carbonsäure aus dem Resist herausgelöst. Die Behandlung des Resists mit dem Vernetzungsreagenz erfolgt vorzugsweise bei Raumtemperatur; falls erforderlich oder zweckmäßig, kann diese Behandlung aber auch bei erhöhter Temperatur vorgenommen werden.

Der Behandlung des Resists mit dem Vernetzungsreagenz schließt sich eine Flutbelichtung an, d.h. eine Belichtung ohne Maske. Vor der Flutbelichtung kann der Resist vorteilhaft einer Temperaturbehandlung unterworfen werden, wozu er kurzzeitig, beispielsweise für 60 s, bei 90 bis 110°C getempert wird. Nach der Flutbelichtung wird der Resist kurzzeitig mit einer metallhaltigen organischen Verbindung behandelt, die wenigstens eine funktionelle Gruppe aufweist, welche mit den reaktiven Gruppen des Basispolymers eine chemische Reaktion eingehen kann. Diese Behandlung erfolgt vorteilhaft mit einer wäßrig-alkoholischen Lösung und vorzugsweise wiederum bei Raumtemperatur.

Die Behandlung des Resists mit der metallhaltigen Verbindung führt - infolge der dabei ablaufenden chemischen Reaktion - zu einer selektiven Zunahme der Schichtdicke in den zweitbelichteten, d.h. in den unblockierten Bereichen. Dieser Schichtzuwachs, der insbesondere vertikal erfolgt, ist über die Belichtungsdosis (bei der Flutbelichtung) sowie über die Dauer der Behandlung und die Konzentration der dabei verwendeten Lösung gezielt kontrollier- und einstellbar. Damit ist es möglich, neben 1:1-Abbildungen hochaufgelöster Subhalbmikrostrukturen von derzeit ca. 0,25 μm (Linie/Graben) auch solche mit wesentlich engeren Gräben und einem hohen Aspektverhältnis zu realisieren. Das Resistsystem beinhaltet somit ein hohes Optimierungspotential.

Nach der Behandlung mit der metallhaltigen Verbindung wird der Resist im Sauerstoffplasma geätzt, d.h. es erfolgt eine Trockkenentwicklung. Dabei werden hochaufgelöste positive Reststrukturen mit steilen Flanken erhalten. Auch im Vergleich zu der in DE-A-3 913 434 beispielhaft angeführten Erzeugung positiver Strukturen (siehe dort Beispiel 6) weist das erfindungsgemäße Verfahren den Vorteil einer deutlich höheren Auflösung auf; das beschriebene Verfahren erfordert außerdem eine weitere Resistkomponente, nämlich einen photoaktiven Säurebildner.

Die Vorteile der Erfindung gegenüber vergleichbaren bekannten Verfahren sind insbesondere in folgendem begründet:

- Prozeßführung, d.h. Behandlung des Resists mit den chemischen Reagenzien, bei Raumtemperatur und -klima;
- kurze Behandlungszeiten (im allgemeinen 30 bis 90 s);
- der gesamte Prozeß ist vollständig in bestehende Anlagen integrierbar; so kann beispielsweise die Behandlung des Resists in bestehenden Puddle- oder Sprühentwicklern vorgenommen werden, d.h. es sind auch keine zusätzlichen Investitionen erforderlich;
- hohe Ätzresistenz der mit der metallhaltigen Verbindung behandelten und auf diese Weise metallisierten Bereiche des Resists gegen Sauerstoffplasmen.

Die Erfindung kann darüber hinaus vorteilhaft nicht nur bei Einlagensystemen, sondern auch bei - trokkenentwickelbaren - Zweilagensystemen Anwendung finden. Der reaktive Resist wird dabei, als dünne Lage, auf eine trockenätzbare Planarisierungsschicht aufgebracht, die - je nach den Anforderungen - frei wählbar ist. Im übrigen dient als Unterlage, d.h. als Substrat, im allgemeinen Halbleitermaterial, Metall, Keramik oder dergleichen.

Beim erfindungsgemäßen Verfahren wird vorzugsweise ein Basispolymer eingesetzt, das als chemisch reaktive Gruppen Anhydridgruppen aufweist; daneben kommen als reaktive Gruppen beispielsweise auch Epoxid- und Imidgruppen sowie Isocyanatgruppen, gegebenenfalls in verkappter Form, und Enolethergruppen in Betracht. Ein geeignetes Basispolymer mit Anhydridgruppen ist beispielsweise ein Copolymer, das zu 10 bis 55 Mol-% aus Maleinsäureanhydridmonomeren aufgebaut ist; als Comonomere dienen dabei insbesondere aromatische Verbindungen, wie Styrol. Eine Vielzahl von weiteren geeigneten Polymeren ist in DE-A-3 913 434 aufgeführt.

Als polyfunktionelle metallfreie organische Verbindung, d.h. als Vernetzer, wird beim erfindungsgemäßen Verfahren vorzugsweise ein Polyamin verwendet, d.h. eine Verbindung mit wenigstens zwei Aminogruppen; vorteilhaft dienen dazu aliphatische Polyamine, auch solche mit aromatischen Partialstrukturen. Geeignete polyfunktionelle Amine sind beispielsweise Triethylentetramin, Tris(2-aminoethyl)-amin, N.N'-Bis(3-aminopropyl)-1.2-ethylendiamin und 3-(Aminomethyl)-benzylamin. Neben Polyaminen kommen auch Verbindungen mit wenigstens zwei phenolischen OH-Gruppen und auch geeignete polyfunktionelle Alkohole in Betracht. Die Vernetzungsreagenzien gelangen vorteilhaft in Form wäßriger Lösungen zum Einsatz. Ist der Vernetzer, beispielsweise das Polyamin, in Wasser nur sehr wenig oder sogar unlöslich, so können auch Lösungen in variablen Gemischen aus Wasser und geeigneten organischen Lösungsmitteln, wie Alkoholen, insbesondere Isopropanol, verwendet werden.

Die metallhaltige organische Verbindung, die beim erfindungsgemäßen Verfahren Verwendung findet, ist vorzugsweise eine Organosiliciumverbindung; vorteilhaft dient dazu ein Diaminosiloxan. Weitere geeignete Verbindungen - neben aminofunktionellen Organosiloxanen - sind beispielsweise hydroxyfunktionelle Organosiloxane sowie amino- oder hydroxyfunktionelle Organosilane. Derartige Verbindungen sind beispielsweise in DE-A-3 913 434 beschrieben. Neben Organosiliciumverbindungen kommen auch andere metallhaltige organische Verbindungen, deren Metalle schwer ätzbare, stabile Oxide bilden, in Betracht, wie magnesium-, aluminium-, titan-, vanadin- und zinnhaltige Verbindungen. Die metallhaltigen organischen Verbindungen, im allgemeinen Silylierungsreagenzien, gelangen vorteilhaft in Form einer wäßrig-alkoholischen Lösung zum Einsatz; als Alkohol wird dabei insbesondere Isopropanol verwendet.

Anhand von Ausführungsbeispielen soll die Erfindung noch näher erläutert werden. Zur Durchführung des erfindungsgemäßen Verfahrens dienen dabei folgende Ausgangsmaterialien bzw. Behandlungsreagenzien (MT = Masseteile):

- Basispolymer (1):
  Copolymer aus Maleinsäureanhydrid und Styrol, hergestellt durch radikalische Polymerisation der beiden Monomeren mit Azoisobuttersäurenitril als Initiator und einem Alkylmercaptan als Regler.
- Basispolymer (2):

Copolymer aus Maleinsäureanhydrid und Styrol, hergestellt durch radikalische Polymerisation der beiden Monomeren mit Azoisobuttersäurenitril als Initiator (ohne Regler).

- Photoaktive Komponente (1):

  Diester von Bisphenol A mit Naphthochinondiazid-4-sulfonsäure.

- Vernetzungslösung (1):

  Wäßrige Lösung, bestehend aus 2 MT Tris (2-aminoethyl)-amin und 98 MT Wasser.

- Vernetzungslösung (2):

  Wäßrige Lösung, bestehend aus 2 MT Triethylentetramin und 98 MT Wasser.

- Vernetzungslösung (3):

  Wäßrige Lösung, bestehend aus 2 MT N-(3-Aminopropyl)-1.4-butandiamin und 98 MT Wasser.

- Vernetzungslösung (4):

  Wäßrige Lösung, bestehend aus 2 MT N.N'-Bis (3-aminopropyl)-1.4-butandiamin und 98 MT Wasser.

- Vernetzungslösung (5):

  Wäßrige Lösung, bestehend aus 4 MT N.N'-Bis (3-aminopropyl)-1.2-ethylendiamin und 96 MT Wasser.

- Silylierungslösung (1):

  Wäßrig-alkoholische Lösung, bestehend aus 2 MT Diaminosiloxan, 78,4 MT Isopropanol und 19,6 MT Wasser; vorzugsweise wird ein $\alpha,\omega$-aminofunktionelles Siloxan, insbesondere mit zwei endständigen Aminopropylgruppen und 2 bis 20 Siliciumatomen in der Kette, verwendet, beispielsweise das handelsübliche Produkt Tegomer A-Si 2120 (Fa. Goldschmidt).

- Silylierungslösung (2):

  Wäßrig-alkoholische Lösung, bestehend aus 1 MT Diaminosiloxan (Tegomer A-Si 2120), 79,2 MT Isopropanol und 19,8 MT Wasser.

- Silylierungslösung (3):

  Wäßrige Lösung, bestehend aus 2 MT Bis (3-aminopropyl)-tetramethyldisiloxan, 1 MT Emulgator und 97 MT Wasser.

Beispiel 1

Auf einen Siliciumwafer wird der käufliche Positivresist TSMR 8900 (Fa. Tokyo Ohka Kogyo Co.) aufgeschleudert (4000 rpm, 20 s) und 5 min bei 90°C getrocknet; dann wird 35 min im Umluftofen bei 240°C ausgeheizt. Nach dem Ausheizen beträgt die Dicke des als Planarisierungsschicht dienenden Resists 1,3 µm.

Auf die Planarisierungsschicht wird ein Resist, bestehend aus 9,75 MT Basispolymer (1), 5,25 MT photoaktive Komponente (1) und 85 MT 2-Methoxy-l-propylacetat, aufgeschleudert (4500 rpm, 20 s). Nach Trocknung bei 100°C/60 s auf einer Hotplate beträgt die Schichtdicke dieses Topresists 320 nm. Der Resist wird dann durch eine Maske mit 100 mJ/cm² belichtet (Canon DUV-Stepper: $\lambda = 248$ nm, NA = 0,37), 60 s mit der Vernetzungslösung (1) behandelt, 30 s mit Wasser gespült und 2 min bei 100°C getempert. Nach einer DUV-Flutbelichtung (ohne Maske) mit 150 mJ/cm² wird der Resist 45 s mit der Silylierungslösung (1) behandelt und dann 30 s mit Isopropanol gespült; hierbei werden lediglich die bei der ersten Belichtung nicht bestrahlten Bereiche silyliert. Anschließend wird der Siliciumwafer in eine Plasmaätzanlage (Leybold Heraeus, Typ Z 401) gebracht und der Resist im Sauerstoffplasma trocken entwickelt ($O_2$/RIE: 0.8 Pa (6 mTorr) Gasdruck, 500 V Biasspannung). Es werden positive Strukturen von 0,3 µm mit senkrechten Flanken und einem Steg/Graben-Verhältnis von 1:1 erhalten.

Beispiel 2

Ein Resist entsprechend Beispiel 1 wird in der dort beschriebenen Weise auf die Unterlage aufgebracht und getrocknet und dann durch eine Maske mit 70 mJ/cm² belichtet, 60 s mit der Vernetzungslösung (2) behandelt und 30 s mit Wasser gespült. Nach Temperung, DUV-Flutbelichtung und Silylierung entsprechend Beispiel 1 wird in einer Plasmaätzanlage (Material Research Corporation, Typ MIE 720) trocken entwickelt ($O_2$/RIE: 0.8 Pa (6 mTorr) Gasdruck, 50 V Biasspannung, mit Magnet). Es werden positive Strukturen mit senkrechten Flanken von 0,25 µm erhalten.

Beispiel 3

Ein Resist entsprechend Beispiel 1 wird in der in Beispiel 2 beschriebenen Weise auf die Unterlage aufgebracht, getrocknet und belichtet und dann 60 s mit der Vernetzungslösung (3) behandelt und 30 s mit Wasser gespült. Nach einer NUV-Flutbelichtung (ohne Maske) mit ca. 200 mJ/cm² und Weiterbehandlung entsprechend Beispiel 1 werden positive Strukturen mit senkrechten Flanken von 0,4 µm und einem Steg/Graben-Verhältnis von 1:1 erhalten.

Beispiel 4

Ein Resist entsprechend Beispiel 1 wird durch eine Maske mit 40 mJ/cm² belichtet (ASM-Stepper: $\lambda = 365$ nm, NA = 0,4), 45 s mit der Vernetzungslösung (5) behandelt, 30 s mit Wasser gespült und 2 min bei 110°C getempert. Nach einer NUV-Flutbelichtung (ohne Maske) mit ca. 200 mJ/cm² wird der Resist 30 s mit der Silylierungslösung (1) behandelt und dann 30 s mit Isopropanol gespült. Anschließend wird der Siliciumwafer in eine Plasmaätzanlage (Leybold Heraeus, Typ Z 401) gebracht und der Resist im Sauerstoffplasma trocken entwickelt ($O_2$/RIE: 0.8 Pa (6 mTorr) Gasdruck, 450 V Biasspannung). Es werden positive Strukturen von 0,5 µm mit senkrechten Flanken erhalten.

Beispiel 5

Auf einen Siliciumwafer wird ein Resist, bestehend aus 13 MT Basispolymer (2), 7 MT photoaktive Komponente (1) und 80 MT 2-Methoxy-l-propylacetat, aufgeschleudert (3000 rpm, 20 s). Nach Trocknung bei 100°C/60 s auf einer Hotplate beträgt die Schichtdicke dieses Resists 1,1 µm. Der Resist wird dann durch eine Maske mit 80 mJ/cm$^2$ belichtet (Canon DUV-Stepper: $\lambda$ = 248 nm, NA = 0,37), 60 s mit der Vernetzungslösung (4) behandelt, 30 s mit Wasser gespült und 2 min bei 100°C getempert. Nach einer DUV-Flutbelichtung (ohne Maske) mit 150 mJ/cm$^2$ wird der Resist 30 s mit der Silylierungslösung (2) behandelt und dann 30 s mit Isopropanol gespült. Anschließend wird der Siliciumwafer in eine Plasmaätzanlage (Leybold Heraeus, Typ Z 401) gebracht und der Resist im Sauerstoffplasma trocken entwickelt (O$_2$/RIE: 0.8 Pa (6 mTorr) Gasdruck, 500 V Biasspannung). Es werden positive Strukturen von 0,4 µm mit senkrechten Flanken erhalten.

Beispiel 6

Ein Resist entsprechend Beispiel 5 wird durch eine Maske mit 40 mJ/cm$^2$ kontaktbelichtet (Gerät MA 56 M / Karl Süss: $\lambda$ = 363 nm), 60 s mit der Vernetzungslösung (2) behandelt, 30 s mit Wasser gespült und 2 min bei 100°C getempert. Nach einer NUV-Flutbelichtung (ohne Maske) mit 180 mJ/cm$^2$ wird der Resist 60 s mit der Silylierungslösung (3) behandelt und dann 30 s mit Isopropanol gespült. Anschließend wird in einer Plasmaätzanlage (Leybold Heraeus, Typ Z 401) im Sauerstoffplasma trocken entwickelt (O$_2$/RIE: 0.8 Pa (6 mTorr) Gasdruck, 500 V Biasspannung). Es werden positive Strukturen mit senkrechten Flanken von 0,5 µm erhalten.

Beispiel 7

Ein Resist entsprechend Beispiel 1 wird durch eine Maske mit 120 mJ/cm$^2$ belichtet (Canon DUV-Stepper: $\lambda$ = 248 nm, NA = 0,37), 60 s mit der Vernetzungslösung (2) behandelt, 30 s mit Wasser gespült und 2 min bei 100°C getempert. Nach einer DUV-Flutbelichtung (ohne Maske) mit ca. 200 mJ/cm$^2$ wird der Resist 60 s mit der Silylierungslösung (1) behandelt und dann 30 s mit Isopropanol gespült. Anschließend wird in einer Plasmaätzanlage (Leybold Heraeus, Typ Z 401) im Sauerstoffplasma trocken entwickelt (O$_2$/ RIE: 0.8 Pa (6 mTorr) Gasdruck, 500 V Biasspannung). Es werden 0,15 µm breite Gräben in der ca. 1,7 µm dicken Resistschicht erhalten.

**Patentansprüche**

1. Verfahren zur Erzeugung einer hochaufgelösten Resiststruktur mit steilen Flanken, **dadurch gekennzeichnet,**

- daß auf ein Substrat eine Photoresistschicht aus einem chemisch reaktive Gruppen enthaltenden Polymer und einer photoaktiven Komponente auf der Basis von Diazoketon oder Chinondiazid aufgebracht wird,
- daß die Photoresistschicht bildmäßig belichtet wird,
- daß die belichtete Photoresistschicht mit einer polyfunktionellen organischen Verbindung mit funktionellen Gruppen, die zu einer chemischen Reaktion mit den reaktiven Gruppen des Polymers befähigt sind, behandelt wird,
- daß nachfolgend eine Flutbelichtung erfolgt,
- daß die derart belichtete Photoresistschicht mit einer metallhaltigen organischen Verbindung mit wenigstens einer funktionellen Gruppe, die zu einer chemischen Reaktion mit den reaktiven Gruppen des Polymers befähigt ist, behandelt wird,
- und daß die derart behandelte Photoresistschicht in einem sauerstoffhaltigen Plasma geätzt wird.

2. Verfahren nach Anspruch 1, **dadurch gekennzeichnet**, daß ein Polymer mit Anhydridgruppen als chemisch reaktive Gruppen eingesetzt wird.

3. Verfahren nach Anspruch 1 oder 2, **dadurch gekennzeichnet**, daß als polyfunktionelle organische Verbindung ein Polyamin verwendet wird.

4. Verfahren nach Anspruch 3, **dadurch gekennzeichnet**, daß ein aliphatisches Polyamin verwendet wird.

5. Verfahren nach einem der Ansprüche 1 bis 4, **dadurch gekennzeichnet**, daß als metallhaltige organische Verbindung eine Organosiliciumverbindung verwendet wird.

6. Verfahren nach Anspruch 5, **dadurch gekennzeichnet**, daß ein Diaminosiloxan verwendet wird.

7. Verfahren nach einem oder mehreren der Ansprüche 1 bis 6, **dadurch gekennzeichnet**, daß die Behandlung der Photoresistschicht mit der polyfunktionellen organischen Verbindung bei Raumtemperatur erfolgt.

8. Verfahren nach einem oder mehreren der Ansprüche 1 bis 7, **dadurch gekennzeichnet**, daß die Photoresistschicht mit einer wäßrig-alkoholischen Lösung der metallhaltigen organischen Verbindung behandelt wird.

9. Verfahren nach einem oder mehreren der Ansprüche 1 bis 8, **dadurch gekennzeichnet,** daß die Photoresistschicht vor der Flutbelichtung einer Temperaturbehandlung unterworfen wird.

10. Verfahren nach einem oder mehreren der Ansprüche 1 bis 9, **dadurch gekennzeichnet,** daß die Photoresistschicht auf eine trockenätzbare Planarisierungsschicht aufgebracht wird.

## Claims

1. Method for producing a high-resolution resist structure having steep edges, characterised

   - in that a photoresist layer consisting of a polymer, which contains chemically reactive groups, and a photoactive component based on diazoketone or quinone diazide is deposited onto a substrate,
   - in that the photoresist layer is exposed with a patterned image,
   - in that the exposed photoresist layer is treated with a polyfunctional organic compound having functional groups, which are capable of a chemical reaction with the reactive groups of the polymer,
   - in that a flood exposure then takes place,
   - in that the photoresist layer which has been exposed in this way is treated with a metal-containing organic compound having at least one functional group, which is capable of a chemical reaction with the reactive groups of the polymer, and
   - in that the photoresist layer which has been treated in this way is etched in an oxygen-containing plasma.

2. Method according to claim 1, characterised in that a polymer having anhydride groups as chemically reactive groups is used.

3. Method according to claim 1 or 2, characterised in that a polyamine is used as a polyfunctional organic compound.

4. Method according to claim 3, characterised in that an aliphatic polyamine is used.

5. Method according to one of the claims 1 to 4, characterised in that an organosilicon compound is used as a metal-containing organic compound.

6. Method according to claim 5, characterised in that a diaminosiloxane is used.

7. Method according to one or more of the claims 1 to 6, characterised in that the treatment of the photoresist layer with the polyfunctional organic compound takes place at room temperature.

8. Method according to one or more of the claims 1 to 7, characterised in that the photoresist layer is treated with an aqueous-alcoholic solution of the metal-containing organic compound.

9. Method according to one or more of the claims 1 to 8, characterised in that the photoresist layer is subjected to a temperature treatment before the flood exposure.

10. Method according to one or more of the claims 1 to 9, characterised in that the photoresist layer is deposited onto a dry-etchable planarisation layer.

## Revendications

1. Procédé pour réaliser une structure de réserve à haute résolution avec des flancs abrupts, caractérisé

   - en ce qu'on dépose sur un substrat, une couche de photo réserve constituée d'un polymère contenant des groupes chimiquement réactionnels et d'un composant photoactif à base de diazocétone ou de quinonediazide,
   - en ce que la couche de photoréserve est exposée sous forme d'image,
   - en ce que la couche de photoréserve exposée est traitée par un composé organique polyfonctionnel avec des groupes fonctionnels qui sont capables de réagir chimiquement avec les groupes réactionnels du polymère,
   - en ce qu'on effectue ensuite un éclairage complet,
   - en ce que la couche de photoréserve ainsi exposée est traitée par un composé organique contenant un métal avec au moins un groupe fonctionnel qui est capable de réagir chimiquement avec les groupes réactionnels du polymère,
   - et en ce que la couche de photoréserve ainsi traitée est gravée dans un plasma contenant de l'oxygène.

2. Procédé selon la revendication 1, caractérisé en ce qu'on utilise un polymère avec des groupes anhydrides à titre de groupes chimiquement réactionnels.

3. Procédé selon la revendication 1 ou 2, caractérisé en ce qu'on utilise une polyamine à titre de composé organique polyfonctionnel.

4. Procédé selon la revendication 3, caractérisé en ce qu'on utilise une polyamine aliphatique.

5. Procédé selon l'une des revendications 1 à 4, caractérisé en ce qu'on utilise à titre de composé organique contenant un métal un composé d'organosilicium.

6. Procédé selon la revendication 5, caractérisé en ce qu'on utilise un diaminosiloxane.

7. Procédé selon une ou plusieurs des revendications 1 à 6, caractérisé en ce que le traitement de la couche de photo réserve par un composé organique polyfonctionnel est effectué à température ambiante.

8. Procédé selon une ou plusieurs des revendications 1 à 7, caractérisé en ce que la couche de photo réserve est traitée par une solution aqueuse-alcoolique du composé organique contenant un métal.

9. Procédé selon une ou plusieurs des revendications 1 à 8, caractérisé en ce que la couche de photoréserve est soumise à un traitement thermique avant l'éclairage complet.

10. Procédé selon une ou plusieurs des revendications 1 à 9, caractérisé en ce que la couche de photoréserve est déposée sur une couche d'aplanissement susceptible d'être gravée à sec.